# EUROPEAN PATENT SPECIFICATION

(11) **EP 3 639 944 B1**
(45) Date of publication and mention of the grant of the patent: **18.08.2021**
(21) Application number: 19202254.9
(22) Date of filing: 09.10.2019
(51) Int. Cl.: B21F 5/00, B21D 28/16, B21J 1/02, B21J 5/00, B21J 5/08, B21J 5/10, H01L 21/48, H01S 5/022, B21J 5/02, B21F 11/00

(54) **METHOD OF MANUFACTURING EYELET**
VERFAHREN ZUR HERSTELLUNG EINER ÖSE
PROCÉDÉ DE FABRICATION D' OEILLET

(30) Priority: 19.10.2018 JP 2018197127
(43) Date of publication of application: 22.04.2020
(73) Proprietor: SHINKO ELECTRIC INDUSTRIES CO., LTD., Nagano-shi, Nagano 381-2287 (JP)
(72) Inventor: MOMOSE, Takatoshi, Nagano-shi, Nagano 381-2287 (JP)
(74) Representative: Regimbeau

(56) References cited:
- JP-A- S6 182 937
- JP-A- 2000 071 046
- JP-A- 2000 140 976
- US-B1- 6 293 164
- US-B2- 9 120 143

## Description

### FIELD

The embodiments discussed herein relate to a method of manufacturing an eyelet.

### BACKGROUND

A metal eyelet is used, for example, in a light emitting device including a laser diode. In such a light emitting device, an eyelet is generally in a disk shape, and a laser diode is mounted on the eyelet, and a heat sink or the like is provided as needed. Also, a lead electrically insulated from the eyelet and electrically connected to the laser diode is provided. Eyelets may be used for products other than light emitting devices.

An eyelet can be manufactured by press work, for example. More specifically, a metal base material having a plate shape is prepared, the metal base material is punched through to form a first processed product in a disk shape having a smaller diameter than the metal base material, and the outer peripheral portion of the first processed product is removed by shaving to form a second processed product. Also, as needed, a through hole is formed by press work and cutting work.

However, in the method of manufacturing the eyelet described above, eyelets are mainly manufactured by press work, but the press work has a low material yield, which may result at worst in disposal of 90% or more of products.

In view of the above, it is an object of one aspect of the embodiments to provide a method of manufacturing an eyelet that can improve a material yield.

### [Related-Art Documents]

[Patent Document]
[Patent Document 1] International Publication Pamphlet No. WO 2015/113746
JP 2000 071046 discloses a method of manufacturing an eyelet, comprising the steps of forming a metal base material by cutting a metal wire material, flattening a first face and a second face of the metal base material by applying pressure to the metal base material and simultaneously forming a base body of which width is greater than a width of the metal base material by applying forge processing on the metal base material of which the first face and the second face are flattened and forming a through hole penetrating through the base body in a thickness direction by punching through the base body.

### SUMMARY

According to the invention, there is provided the method as defined in appended claim 1. Preferred embodiments are defined by the dependent claims.

According to the above method, the material yield can be increased.

### BRIEF DESCRIPTION OF DRAWINGS

FIGs. 1A and 1B are drawings illustrating an example of an eyelet manufactured according to a first embodiment;
FIGs. 2A and 2B are drawings (part 1) illustrating a step of manufacturing the eyelet according to the invention;
FIGs. 3A and 3B are drawings (part 2) illustrating a step of manufacturing the eyelet according to the first embodiment of the invention;
FIGs. 4A and 4B are drawings (part 3) illustrating a step of manufacturing the eyelet according to the invention;
FIGs. 5A to 5D are cross sectional views illustrating an example of an eyelet according to comparative examples;
FIGs. 6A and 6B are drawings (part 1) illustrating an example of an eyelet manufactured according to a variation of the first embodiment;
FIGs. 7A and 7B are drawings (part 2) illustrating an example of an eyelet manufactured according to the variation of the first embodiment;
FIGs. 8A and 8B are drawings illustrating an example of a step of manufacturing an eyelet according to the variation of the first embodiment; and
FIGs. 9A and 9B are drawings illustrating an example of a light emitting device.

### DESCRIPTION OF EMBODIMENTS

In the following, embodiments will be described with reference to the accompanying drawings. In these drawings, the same elements are referred to by the same references, and duplicate descriptions may be omitted as appropriate.

### <First Embodiment>

### [Structure of Eyelet manufactured According to First Embodiment]

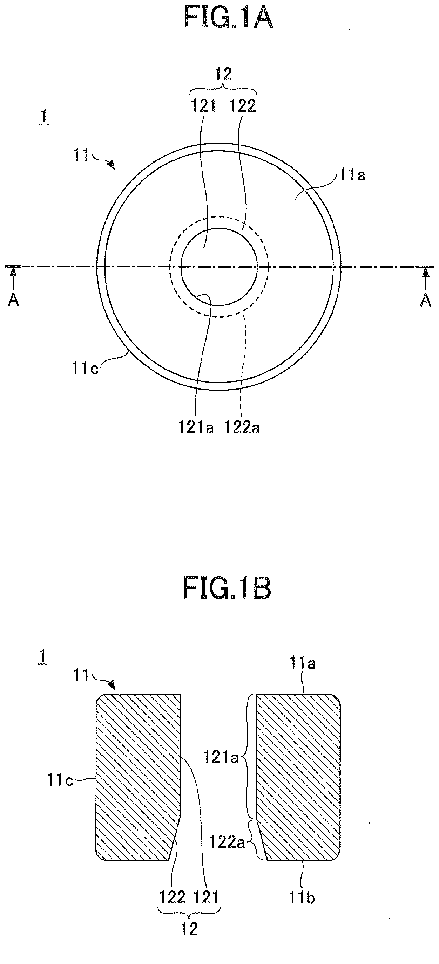

First, a structure of an eyelet 1 manufactured according to a first embodiment will be described. FIGs. 1A and 1B are drawings illustrating an example of the eyelet 1 manufactured according to the first embodiment. FIG. 1A is a planar view of the eyelet 1, and FIG. 1B is a cross-sectional view of the eyelet 1 taken along the line A-A of FIG. 1A.

With reference to FIGs. 1A and 1B, the eyelet 1 according to the first embodiment includes a base body 11 and a through hole 12.

The base body 11 is a member in a disk shape. A rollover may be formed at a boundary between a first face 11a and an outer circumferential face 11c of the base body 11 and at a boundary between a second face 11b and the outer circumferential face 11c of the base body 11.

The term "rollover" means a rounded edge that is made in an area of a material next to an edge of a die by yielding in the direction of the applied force when the material is forged in the die.

Note that in the present application, the "disk shape" refers to a shape whose planar shape is substantially in a circular shape and which has a predetermined thickness. The thickness with respect to the diameter is not limited. Also, shapes partially formed with a recess, a protrusion, a through hole, or the like are included in the "disk shape". Further, in the present application, "planar view" refers to viewing an object from a normal direction of the first face 11a of the base body 11, and "planar shape" refers to a shape of an object viewed from the normal direction of the first face 11a of the base body 11.

The outer diameter of the base body 11 is not particularly limited and can be determined as appropriate according to the purpose. For example, the outer diameter may be approximately in a range of ϕ 3 mm to ϕ 8 mm. The thickness of the base body 11 is not particularly limited and can be determined as appropriate according to the purpose. For example, the thickness of the base body 11 may be approximately in a range of 1 mm to 5 mm.

The base body 11 can be made of a metal material such as Kovar (which is a nickel-cobalt ferrous alloy), iron, an iron-nickel alloy, or SUS 304 (stainless steel), for example. A plating process may be applied to the surface of the base body 11.

The through hole 12 is formed in the center of the base body 11 to penetrate through the base body 11 from the first face 11a to the second face 11b. The through hole 12 has a shape including a first hole portion 121 and a second hole portion 122. The first hole portion 121 is formed at the first face 11a of the base body 11, and has a predetermined inner diameter (substantially constant inner diameter). The second hole portion 122 is in a tapered shape of which inner diameter gradually increases away from the first hole portion 121 toward the second face 11b of the base body 11. The second hole portion 122 is formed in a continuous manner with the first hole portion 121. The first hole portion 121 and the second hole portion 122 can be formed in a concentric manner, for example.

In the eyelet 1, the outer circumferential face 11c of the base body 11 is a forged surface. The inner circumferential face 121a of the first hole portion 121 of the through hole 12 is a shear surface. The inner circumferential face 122a (tapered face) of the second hole portion 122 of the through hole 12 is a fracture surface.

Here, the shear surface is a smooth surface cut and punched by the cutting edge of a die for pressing, and a diameter that is practically as designed can be obtained. The fracture surface is a rough surface cut, in a tearing manner, by a material pushed by the cutting edge of a die for pressing, and a diameter that is as designed cannot be obtained. The forged surface is a relatively smooth surface formed by forging (a method for forming metal into a predetermined shape by causing plastic deformation through application of pressure), but has a lower degree of smoothness than the shear surface.

### [Method of Manufacturing Eyelet According to First Embodiment]

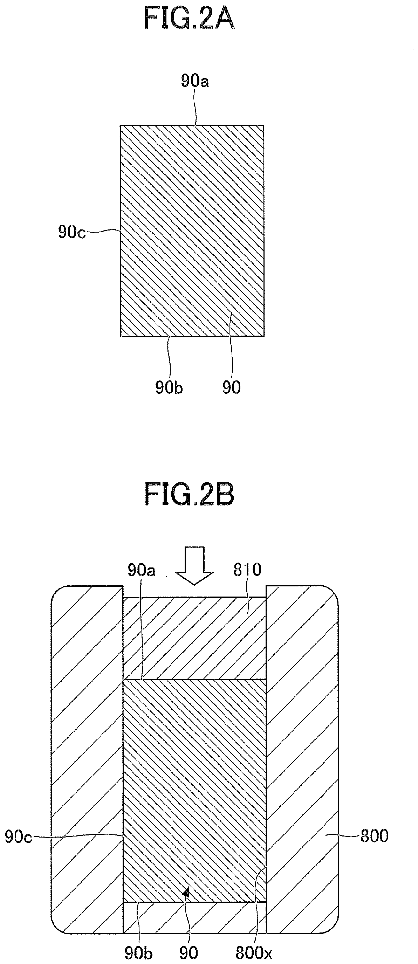

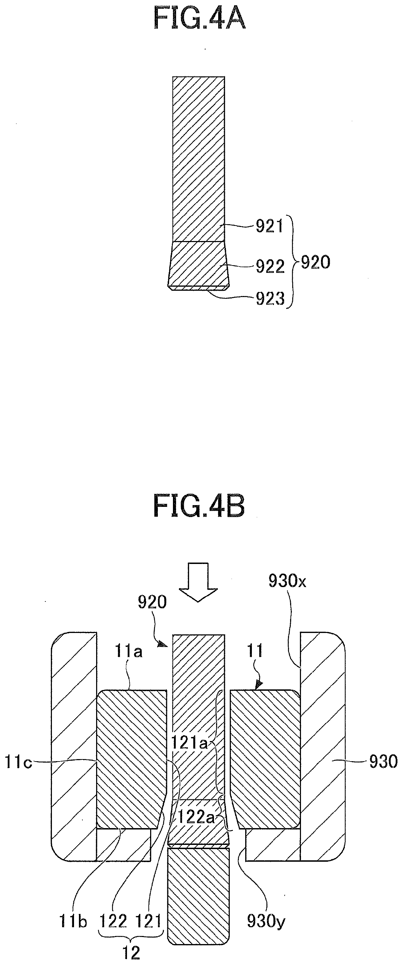

Next, a method of manufacturing the eyelet 1 according to the first embodiment will be described. FIGs. 2A and 2B to FIGs. 4A and 4B are drawings illustrating an example of the manufacturing steps of the eyelet 1 according to the first embodiment.

First, in the step illustrated in FIG. 2A, a metal base material 90 in a cylindrical shape made of a metal material such as Kovar, iron, an iron-nickel alloy, or SUS 304 is prepared. According to the invention, the metal base material 90 is formed by cutting metal wire material. As illustrated in FIG. 2A, the metal base material 90 includes a first face 90a, a second face 90b, and an outer circumferential face 90c. Since the first face 90a and the second face 90b of the metal base material 90 are cut surfaces, the first face 90a and the second face 90b are not smooth.

Subsequently, in the step illustrated in FIG. 2B, the first face 90a and the second face 90b of the metal base material 90 are smoothed. More specifically, first, the metal base material 90 is placed in a recessed portion 800x, of which planar shape is a circular shape, of a die 800, and further, a punch 810 in a disk shape is arranged on the first face 90a of the metal base material 90. The diameters of the punch 810 and the recessed portion 800x are formed in accordance with the diameter of the metal base material 90, and the outer circumferential face of the punch 810 and the outer circumferential face 90c of the metal base material 90 are arranged to be in contact with the inner circumferential face of the recessed portion 800x of the die 800. In general, the die 800 is made by combining multiple components. This is also applicable to other dies explained later.

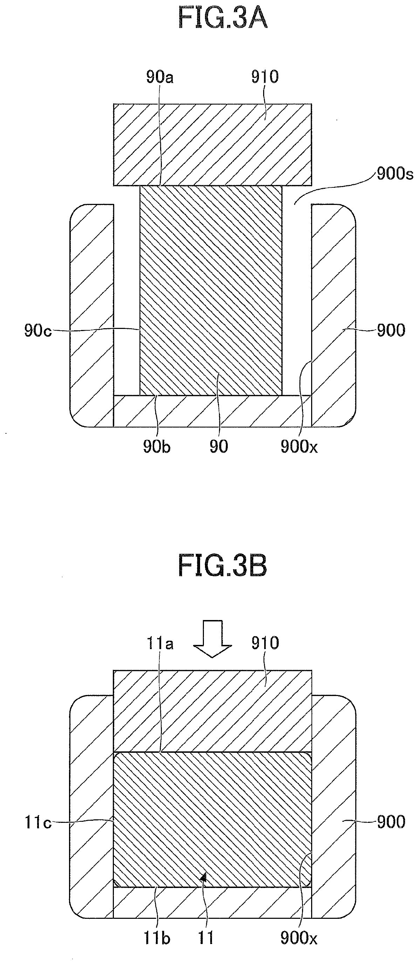

Then, the punch 810 is lowered in the arrow direction along the recessed portion 800x while the punch 810 is caused to engage with the recessed portion 800x, and a pressure within such a range that does not widen the width of the metal base material 90 (i.e., a range in which the diameter is not enlarged) is applied to the metal base material 90, thereby flattening the first face 90a and the second face 90b of the metal base material 90. By flattening the first face 90a and the second face 90b of the metal base material 90, the base body 11 produced in the step of forge processing illustrated in FIG. 3B can be easily processed into a designed shape.

The step of flattening the first face 90a and the second face 90b of the metal base material 90 preferably includes a step of applying pressure to the metal base material 90 from a same side as the first face 90a of the metal base material 90 and a step of applying pressure to the metal base material 90 from a same side as the second face 90b of the metal base material 90. The step of applying pressure to the metal base material 90 from a same side as the second face 90b of the metal base material 90 can be achieved by turning the metal base material 90 upside down and placing the inverted metal base material 90 into the recessed portion 800x.

As necessary, the degree of smoothness of the first face 90a and the second face 90b of the metal base material 90 may be improved by repeating multiple times the step of applying pressure to the metal base material 90 from a same side as the first face 90a of the metal base material 90 and the step of applying pressure to the metal base material 90 from a same side as the second face 90b of the metal base material 90.

Subsequently, in the step illustrated in FIG. 3A, the metal base material 90 of which the first face 90a and the second face 90b have been smoothed is placed within a recessed portion 900x, of which planar shape is a circular shape, of a die 900, and further, a punch 910 in a disk shape is arranged on the first face 90a of the metal base material 90. The diameter of the recessed portion 900x is formed according to the diameter of the base body 11 to be formed, and the metal base material 90 having a diameter smaller than the diameter of the base body 11 is arranged in a substantially central portion of the recessed portion 900x. Therefore, a gap 900s in an annular shape in a planar view is formed between the outer circumferential face 90c of the metal base material 90 and the inner circumferential face of the recessed portion 900x. The diameter of the punch 910 is formed according to the diameter of the base body 11 to be formed, and the punch 910 can engage in the recessed portion 900x of the die 900.

Subsequently, in the step illustrated in FIG. 3B, the metal base material 90 is forged to form the base body 11 in the disk shape of which width is widened to a width larger than that of the metal base material 90 (i.e., the diameter is enlarged). According to the invention, the punch 910 is lowered in the arrow direction along the recessed portion 900x while the punch 910 is caused to engage with the recessed portion 900x of the die 900, and a pressure is applied to the metal base material 90 to plastically deform the metal base material 90 to such a degree that the outer circumferential face 90c of the metal base material 90 comes into contact with the inner circumferential face of the recessed portion 900x. As a result, the base body 11 in the disk shape including the first face 11a, the second face 11b, and the outer circumferential face 11c is formed. The outer circumferential face 11c of the base body 11 becomes a forged surface. With the forge processing, a rollover is formed at a boundary between the first face 11a and the outer circumferential face 11c of the base body 11 and at a boundary between the second face 11b and the outer circumferential face 11c of the base body 11.

In the forge processing, a relatively large rollover is formed at a boundary between the first face 11a and the outer circumferential face 11c of the base body 11 and at a boundary between the second face 11b and the outer circumferential face 11c of the base body 11. In a case where this rollover exceeds the required specifications, a step of lowering the punch 910 in the arrow direction along the recessed portion 900x while the punch 910 is caused to engage with the recessed portion 900x of the die 900 to apply pressure to the base body 11 and reduce the size of the rollover may be provided after the step of forming the base body 11.

As necessary, the size of the rollover may be further reduced by repeating multiple times at least one of the step of applying pressure to the base body 11 from a same side as the first face 11a of the base body 11 and the step of applying pressure to the base body 11 from a same side as the second face 11b of the base body 11.

Subsequently, in the step illustrated in FIG. 4A, a PW (Press Working) punch 920 is prepared as a hole punch. The PW punch 920 includes a shape in which a cylindrical portion 921, a truncated cone portion 922, and an inverted truncated cone portion 923 are continuously formed. The truncated cone portion 922 is a tapered shape of which diameter increases away from the cylindrical portion 921 toward the inverted-truncated cone portion 923. The inverted-truncated cone portion 923 is a tapered shape of which diameter decreases away from the truncated cone portion 922 toward the end of the PW punch 920. However, the use of the PW punch 920 as the hole punch is an example, and a hole punch having a shape different from the PW punch 920 may be used.

Subsequently, in the step illustrated in FIG. 4B, the base body 11 is arranged in a recessed portion 930x, of which planar shape is a circular shape, of a die 930. At a center of a bottom surface of the recessed portion 930x, a through hole 930y is formed. Then, the PW punch 920 punches through (i.e., performing press processing on) a substantially central portion of the base body 11 from the first face 11a to the second face 11b, thereby forming the through hole 12 penetrating the base body 11 in the thickness direction. It should be noted that the PW punch 920 is arranged on the base body 11 in such a manner that the inverted-truncated cone portion 923 first comes into contact with the base body 11, thus punching through the base body 11.

The through hole 12 is formed in a shape including a first hole portion 121 and a second hole portion 122. The first hole portion 121 is formed at the side of the first face 11a of the base body 11, and has a predetermined inner diameter. The second hole portion 122 has an inner diameter gradually increasing away from the first hole portion 121 toward the second face 11b of the base body 11. The inner circumferential face 121a of the first hole portion 121 of the through hole 12 is a shear surface. The inner circumferential face 122a (tapered face) of the second hole portion 122 of the through hole 12 is a fracture surface. Since the inner circumferential face 121a of the first hole portion 121 of the through hole 12 is a shear surface, the inner circumferential face 121a is formed into a surface of which degree of smoothness is higher than the outer circumferential face 11c of the base body 11 which is the forged surface. According to the above, the eyelet 1 formed with the through hole 12 in the base body 11 is completed.

It should be noted that the PW punch 920 is fixed in a vertically movable manner to a pressure insertion member (stripper), not illustrated, inserted into the recessed portion 930x together with the PW punch 920. Accordingly, the PW punch 920 can be aligned with respect to the base body 11.

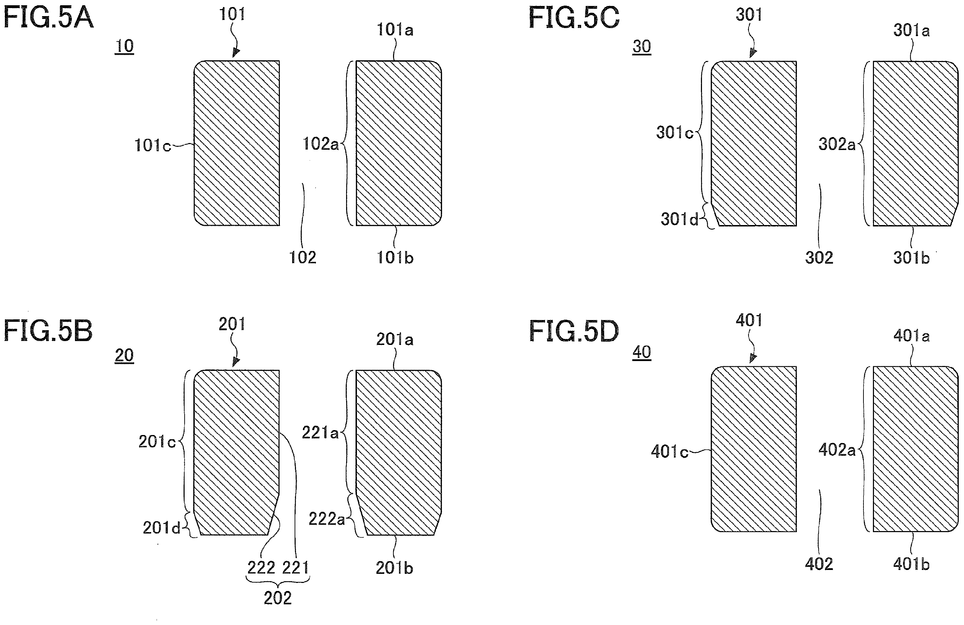

Here, advantages achieved by the eyelet 1 will be described with reference to comparative examples. FIGs. 5A to 5D are cross sectional views illustrating an example of an eyelet 10 according to comparative examples, and illustrate cross-sections corresponding to FIG. 1B.

The eyelet 10 illustrated in FIG. 5A is an example in which both of a base body 101 and a through hole 102 are formed by cutting work. For example, a metal base material of which diameter is larger than that of the base body 101 is prepared, and the base body 101 is formed by applying cutting work to the first face, the second face, and the outer circumferential face of the prepared metal base material. Then, the through hole 102 is formed in the base body 101 by cutting work. In this case, in the eyelet 10, a first face 101a, a second face 101b, and an outer circumferential face 101c of the base body 101 are cut surfaces. Also, the inner circumferential face 102a of the through hole 102 is a cut surface. On the cut surfaces, cutting work marks can be seen. The cutting work marks are formed in, for example, spiral shapes.

An eyelet 20 illustrated in FIG. 5B is an example in which both of a base body 201 and a through hole 202 are formed by press work. For example, a metal base material of which diameter is larger than that of the base body 201 is prepared, the prepared metal base material is pressed, and the outer circumferential side of the metal base material is crushed leaving a shaving margin. Subsequently, by press work, the through hole 202 is formed in the metal base material leaving the shaving margin. Then, the outer circumference of the metal base material having the through hole 202 formed therein is shaved to form the base body 201 having the through hole 202.

In this case, in the eyelet 20, a tapered face 201d is formed, at the side of a second face 201b, on an outer circumferential face 201c of the base body 201. Also, the through hole 202 including a first hole portion 221 located at the side of the first face 201a of the base body 201 and a second hole portion 222 located at the side of the second face 201b of the base body 201 is formed. In the eyelet 20, the outer circumferential face 201c of the base body 201 is a shear surface, and the tapered face 201d is a fracture surface. Also, an inner circumferential face 221a of the first hole portion 221 of the through hole 202 is a shear surface, and an inner circumferential face 222a (tapered face) of the second hole portion 222 of the through hole 202 is a fracture surface.

An eyelet 30 illustrated in FIG. 5C is an example in which a base body 301 is formed by press work, and the through hole 302 is formed by cutting work. For example, a metal base material of which diameter is larger than the base body 301 is prepared, and press work is applied to the prepared metal base material to punch off the outer circumferential side of the metal base material. Then, by cutting work, the through hole 302 is formed in the base body 301.

In this case, in the eyelet 30, a tapered face 301d is formed, at the side of a second face 301b, on an outer circumferential face 301c of the base body 301. In the eyelet 30, the outer circumferential face 301c of the base body 301 is a shear surface, and the tapered face 301d is a fracture surface. On the other hand, an inner circumferential face 302a of the through hole 302 is a cut surface. On the cut surface, cutting work marks can be seen.

An eyelet 40 illustrated in FIG. 5D is an example in which a base body 401 is formed by forge processing, and a through hole 402 is formed by cutting work. For example, a metal base material of which diameter is smaller than the base body 401 is prepared, and the base body 401 is produced by applying forge processing to the prepared metal base material. Then, the through hole 402 is formed in the base body 401 by cutting work.

In this case, in the eyelet 40, an outer circumferential face 401c of the base body 401 is a forged surface. On the other hand, an inner circumferential face 402a of the through hole 402 is a cut surface. On the cut surface, cutting work marks can be seen.

In the eyelet 10 illustrated in FIG. 5A, both of the base body 101 and the through hole 102 are formed by cutting work. As a result, the processing speed cannot be increased, and it takes a longer processing time. The number of eyelets 10 that can be produced per minute is, for example, on an order of single digit.

In the eyelet 20 illustrated in FIG. 5B, both of the base body 201 and the through hole 202 are formed by press work. As a result, the material yield is low, which may result at worst in disposal of 90% or more of products. However, since both of the base body 201 and the through hole 202 are formed by press work, it takes a shorter processing time. The number of eyelets 20 that can be produced per minute is, for example, on an order of tens of units.

In the eyelet 30 illustrated in FIG. 5C, the base body 301 is formed by press work, and the through hole 302 is formed by cutting work. As a result, in the portion made by press work, the material yield is low just like the eyelet 20 illustrated in FIG. 5B, and in the portion made by cutting work, it takes a longer processing time just like the eyelet 10 illustrated in FIG. 5A.

In the eyelet 40 illustrated in FIG. 5D, the base body 401 is formed by forge processing. As a result, the material yield is improved as compared with the case of formation by press work, and it takes a shorter processing time as compared with a case of formation by cutting work. However, since the through hole 402 is formed by cutting work, the processing time with respect to the entirety of the steps is not greatly improved. Furthermore, there is a disadvantage in that a forge device and a cutting device are required.

In contrast, in the eyelet 1 illustrated in FIGs. 1A and 1B, the base body 11 is formed by forge processing, and therefore, the material yield is improved as compared with a case of formation by press work, and it takes a shorter processing time as compared with formation by cutting work. In addition, since the through hole 12 is formed by press work, it takes a shorter processing time as compared with formation by cutting work. In addition, the step of forming the base body 11 by forge processing and the step of forming the through hole 12 by press work can be performed by a single forging machine called a former.

As described above, in the eyelet 1, the base body 11 is formed by forge processing, and the through hole 12 is formed by press work. Therefore, as compared with conventional processing methods, the material yield and the processing time can be greatly improved. With respect to material yield, disposal can be suppressed to such a level that, for example, only about 10% of produced eyelets are to be disposed of. The processing time can be, for example, about the same as that of the eyelets 20 illustrated in FIG. 5B.

It is conceivable to form a counterbore at the side of the second face 11b of the base body 11, and form the through hole 12 by applying press work to the portion thinned by forming the counterbore. However, this method is not preferable since this method entails the addition of the step of forming the counterbore in the base body 11, according to which the processing time increases, and in addition, equipment for counterbore is required.

### <Variations of First Embodiment>

In a variation of the first embodiment, an example of an eyelet of which shape is different from that of the first embodiment is shown. In the variation of the first embodiment, explanations about the same or similar constituent elements as those already explained in the embodiment may be omitted.

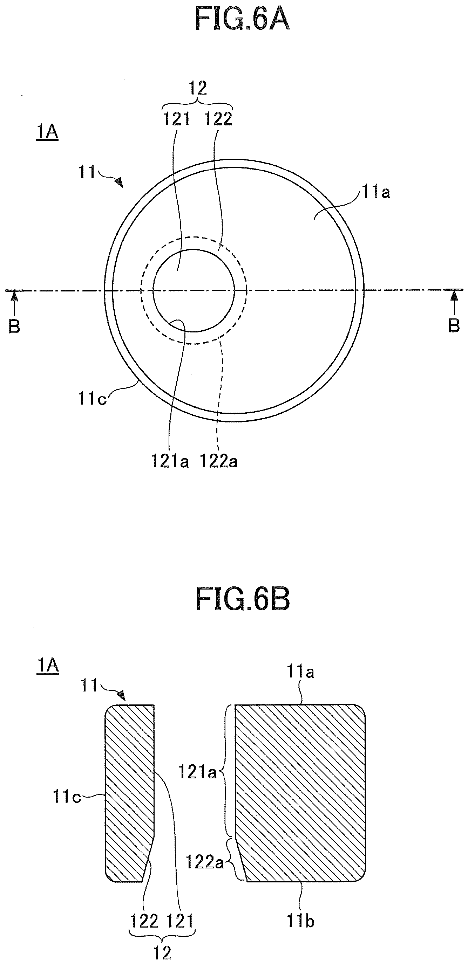

FIGs. 6A and 6B are drawings (part 1) illustrating an example of an eyelet according to a variation of the first embodiment. FIG. 6A is a planar view, and FIG. 6B is a cross-sectional view taken along the line B-B of FIG. 6A.

As illustrated in FIGs. 6A and 6B, an eyelet 1A includes a base body 11 and a through hole 12, but is different from the eyelet 1 (see FIGs. 1A and 1B) in that the position of the through hole 12 is offset from the center of the base body 11. Even in a case where the position of the through hole 12 is offset from the center of the base body 11 just like the eyelet 1A, such eyelets can be produced according to the method explained with reference to FIGs. 2A and 2B to FIGs. 4A and 4B.

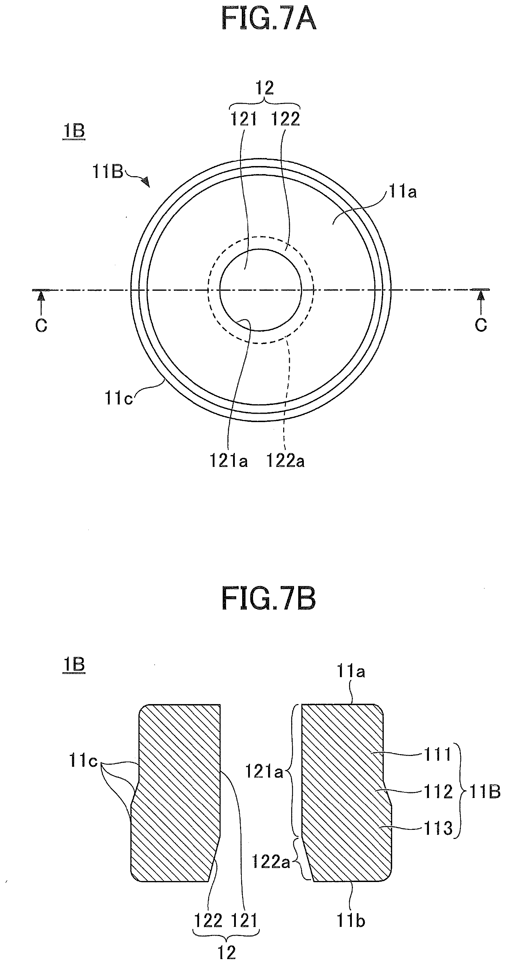

FIGs. 7A and 7B are drawings (part 2) illustrating an example of an eyelet according to another variation of the first embodiment. FIG. 7A is a planar view, and FIG. 7B is a cross-sectional view taken along the line C-C of FIG. 7A.

As illustrated in FIGs. 7A and 7B, an eyelet 1B is different from an eyelet 1 (see FIGs. 1A and 1B) in that the base body 11 is replaced with a base body 11B having a step on the outer circumferential face 11c.

The base body 11B is a member in a disk shape, and includes a small diameter portion 111, a tapered portion 112, and a large diameter portion 113. At one side of the small diameter portion 111, the tapered portion 112 and the large diameter portion 113 are located successively, and on the outer circumferential face 11c of the base body 11B, the portion of the tapered portion 112 includes a gradual step. The diameter of the tapered portion 112 at the side of the small diameter portion 111 is the same as the diameter of the small diameter portion 111. The diameter of the tapered portion 112 at the side of the large diameter portion 113 is the same as the diameter of the large diameter portion 113. The small diameter portion 111, the tapered portion 112, and the large diameter portion 113 can be formed, for example, in a concentric manner.

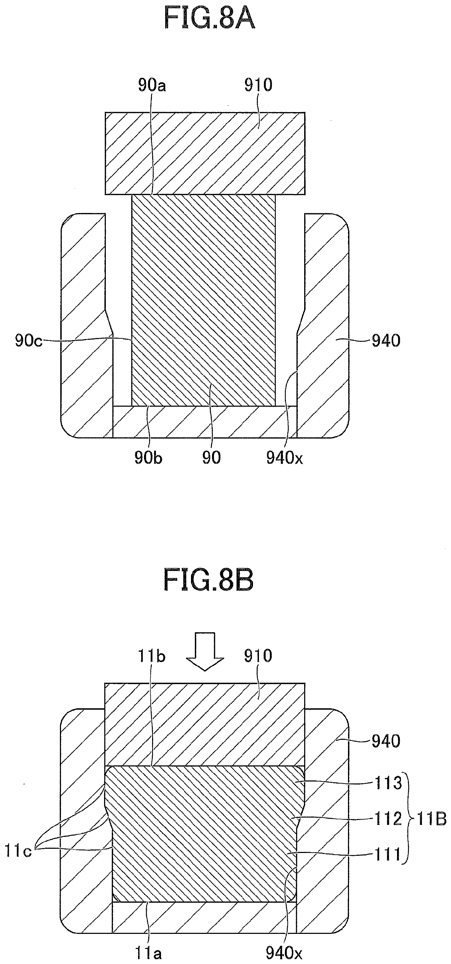

To produce the eyelet 1B, a die 940 illustrated in FIG. 8A may be used instead of a die 900 used in the gradual step of FIG. 3A. The inner circumferential face of a recessed portion 940x, of which planar shape is a circular shape, of a die 940 is in a shape having a step corresponding to the outer circumferential face 11c of the base body 11B. As illustrated in FIG. 8A, the metal base material 90 is arranged in the recessed portion 940x of the die 940, and further, a punch 910 in a disk shape is arranged on the metal base material 90.

As illustrated in FIG. 8B, the punch 910 is lowered in the arrow direction along the recessed portion 940x while the punch 910 is caused to engage with the recessed portion 940x of the die 940, and a pressure is applied to the metal base material 90 to plastically deform the metal base material 90 to such a degree that the outer circumferential face 90c of the metal base material 90 comes into contact with the inner circumferential face of the recessed portion 940x. As a result, the base body 11B in the disk shape including the small diameter portion 111, the tapered portion 112, and the large diameter portion 113 is made. The outer circumferential face 11c of the base body 11 is a forged surface. With the forge processing, a rollover is formed at a boundary between the first face 11a and the outer circumferential face 11c of the base body 11B and at a boundary between the second face 11b and the outer circumferential face 11c of the base body 11B. The steps subsequent thereto are similar to the steps for producing the eyelet 1.

It should be noted that in the steps of FIG. 8B, the base body 11B is formed in a state in which the top and bottom are reversed from FIG. 7B.

### <Example>

An example of a light emitting device using the eyelet will be described. In the example, explanations about the same or similar constituent elements as those already explained in the embodiment may be omitted.

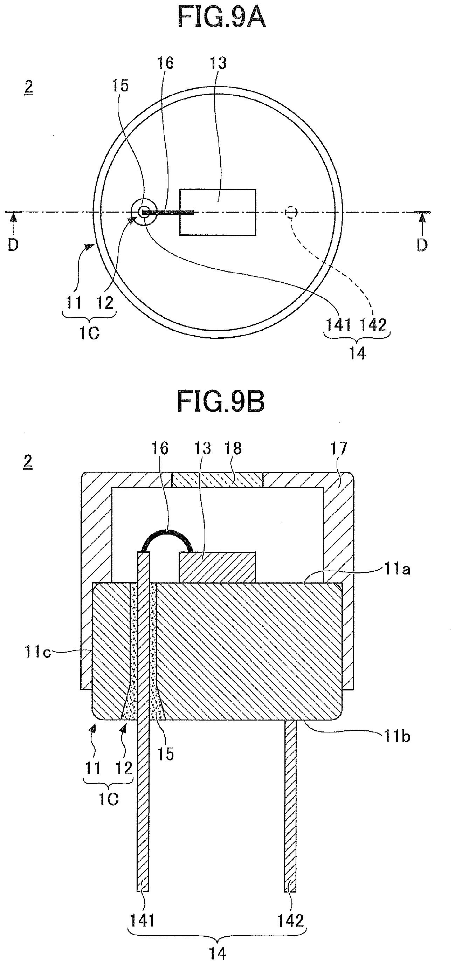

FIGs. 9A and 9B are drawings illustrating an example of a light emitting device 2 according to the second embodiment. FIG. 9A is a planar view, and FIG. 9B is a cross-sectional view taken along the line D-D of FIG. 9A.

With reference to FIGs. 9A and 9B, the light emitting device 2 includes an eyelet 1C, a light emitting element 13, a lead 14, a sealing portion 15, metal wires 16, a cap 17, and a transparent member 18. The light emitting device 2 can be used for, for example, an optical disk device, an optical communication device, or the like. Note that, in FIG. 9A, illustration of the cap 17 and the transparent member 18 are omitted.

The eyelet 1C is different from the eyelet 1 (see FIGs. 1A and 1B) in that the through hole 12 is formed at a position offset from the center of the base body 11, and other features including the method for producing the eyelet 1C are similar to those of the eyelet 1 (see FIGs. 1A and 1B).

The light emitting element 13 is, for example, a semiconductor laser chip, and is mounted on the first face 11a of the base body 11.

The lead 14 includes a first lead 141 and a second lead 142. The first lead 141 is inserted into a through hole 12 penetrating through the base body 11 in the thickness direction such that the longitudinal direction is directed in the thickness direction, and its outer periphery is sealed by the sealing portion 15. A part of the first lead 141 protrudes downward from the second face 11b of the base body 11. The amount of protrusion of the first lead 141 from the second face 11b of the base body 11 may be, for example, approximately 6 mm to 7 mm.

The first lead 141 is made of a metal such as Kovar or an iron-nickel alloy, for example. The sealing portion 15 is made of an insulating material such as a glass material, for example. The first lead 141 is electrically connected to the light emitting element 13.

The second lead 142 is joined to the second face 11b of the base body 11 by welding or the like such that its longitudinal direction is directed in the thickness direction to protrude downward from the second face 11b of the base body 11. The second lead 142 is made of a metal such as Kovar or an iron-nickel alloy. It should be noted that the second lead 142 is joined with the base body 11 so as to be electrically connected to the base body 11, and is electrically connected via the base body 11 to a first electrode (not illustrated) formed on the other face of the light emitting element 13 in contact with the first face 11a of the base body 11.

A second electrode (not illustrated) of the light emitting element 13 is connected to upper ends of the first lead 141, through the metal wire 16 such as a gold wire or a copper wire. The second electrode of the light emitting element 13 and the first lead 141 can be connected through, for example, wire bonding. The light emitting element 13 emits light when a current is passed between the first electrode and the second electrode of the light emitting element 13 through the first lead 141 and the second lead 142, respectively.

The cap 17 is made of, for example, a metal such as iron or copper. The transparent member 18 (window) is provided at a substantially central portion of the cap 17 in plan view. The transparent member 18 is made of glass or the like, for example, and is bonded to the cap 17 by an adhesive (not illustrated) made of low melting point glass or the like. The cap 17 is joined to the outer circumferential face 11c of the base body 11 by, for example, welding or the like, and hermetically seals the light emitting element 13. Light emitted from the light emitting element 13 is emitted passing through the transparent member 18.

In this manner, the eyelet 1C can be used for the light emitting device 2. In the light emitting device 2, the cap 17 is joined to the outer circumferential face 11c of the base body 11 of the eyelet 1C by welding or the like, and the outer circumferential face 11c is a forged surface which is a relatively smooth surface. Therefore, because the contact area between the outer circumferential face 11c and the cap 17 is increased, the reliability of their joint can be enhanced.

Further, although the preferred embodiments and the variation have been described above in detail, the present invention is not limited to these embodiments and the variation, and various variations and modifications may be made without departing from the scope of the appended claims.

## Claims

1. A method of manufacturing an eyelet (1, 1A, 1B, 1C), comprising:
forming a metal base material (90) by cutting a metal wire material;
placing the metal base material (90) in a first recessed portion (800x) of a die (800), the first recessed portion (800x) having a circular planar shape, and arranging a disk-shaped first punch (810) on a first face (90a) of the metal base material (90), such that an outer circumferential face of the first punch (810) and an outer circumferential face (90c) of the metal base material (90) are in contact with an inner circumferential face of the first recessed portion (800x) of the die (800);
flattening the first face (90a) and a second face (90b) of the metal base material (90) by lowering the first punch (810) along the first recessed portion (800x) while the first punch (810) engages with the first recessed portion (800x) so as to apply pressure to the metal base material (90);
placing the metal base material (90) having the flattened first face (90a) and the flattened second face (90b) in a second recessed portion (900x) of a die (900), the second recessed portion (900x) having a circular planar shape, and arranging a disk-shaped second punch (910) on the first face (90a) of the metal base material (90), such that an annular shape gap (900s) in a plan view is formed between the outer circumferential face (90c) of the metal base material (90) and an inner circumferential face of the second recessed portion (900x);
forming a base body (11) of which width is greater than a width of the metal base material (90) by lowering the second punch (910) along the second recessed portion (900x) while the second punch (910) engages with the second recessed portion (900x) so as to apply forge processing on the metal base material (90) of which the first face (90a) and the second face (90b) are flattened; and
forming a through hole (12) penetrating through the base body (11) in a thickness direction by punching through the base body (11).

2. The method according to claim 1, wherein the flattening further comprises:
applying a pressure to the metal base material (90) from a same side as the first face (90a) of the metal base material (90) by lowering the first punch (810) while the first punch (810) is in contact with the first face (90a) of the metal base material (90);
turning the metal base material (90) upside down and placing the turned metal base material (90) in the first recessed portion (800x); and
applying a pressure to the metal base material (90) from a same side as the second face (90b) of the metal base material (90) by lowering the first punch (810) while the first punch (810) is in contact with the second face (90b) of the metal base material (90).

3. The method according to claim 1 or 2, wherein in the forming of the base body (11), a rounded edge is formed at a boundary between the first face (11a) and an outer circumferential face (11c) of the base body (11) and at a boundary between the second face (11b) and the outer circumferential face (11c) of the base body (11), and
the method further comprises, after the forming of the base body (11), reducing at least one of the rounded edge formed at the boundary between the first face (11a) and the outer circumferential face (11c) of the base body (11) and the rounded edge formed at the boundary between the second face (11b) and the outer circumferential face (11c) of the base body (11) by applying a pressure to the base body (11).

4. The method according to claim 3, wherein the reducing of the rounded edge further comprises:
applying a pressure to the base body (11) from a same side as the first face (11a) of the base body (11); and
subsequently applying a pressure to the base body from a same side as the second face (11b) of the base body (11).

5. The method according to any one of claims 1 to 4, wherein the forming of the through hole (12) further comprises punching the base body (11) from the first face (11a) to the second face (11b),
wherein the punching of the base body (11) from the first face (11a) to the second face (11b) results in a shear surface on an inner circumferential face of a first hole portion (121) and a fracture surface on an inner circumferential face of a second hole portion (122), the first hole portion (121) being formed at a side of the first face (11a) of the base body (11) and having a predetermined inner diameter, and the second hole portion (122) having an inner diameter gradually increasing away from the first hole portion (121) toward the second face (11b) of the base body (11).

6. The method according to claim 5, wherein the inner circumferential face (121a) of the first hole portion (121) is smoother than the outer circumferential face (11c) of the base body (11).

7. The method according to any one of claims 1 to 6, wherein the forming of the through hole (12) further comprises punching through the base body (11) upon arranging a punch (920), which has a shape in which a cylindrical portion (921), a truncated cone portion (922), and an inverted-truncated cone portion (923) are formed continuously, on the base body (11) in such a manner that the inverted-truncated cone portion (923) first comes into contact with the base body (11).

## Patentansprüche

1. Verfahren zum Herstellen einer Öse (1, 1A, 1B, 1C), das Folgendes umfasst:
Bilden eines Metallbasismaterials (90) durch Schneiden eines Metalldrahtmaterials;
Platzieren des Metallbasismaterials (90) in einem ersten ausgenommenen Abschnitt (800x) eines Werkzeugs (800), wobei der erste ausgenommene Abschnitt (800x) eine planare Kreisform aufweist, und Anordnen eines scheibenförmigen ersten Durchschlags (810) auf einer ersten Seite (90a) des Metallbasismaterials (90), derart, dass eine Außenumfangsseite des ersten Durchschlags (810) und eine Außenumfangsseite (90c) des Metallbasismaterials (90) mit einer Innenumfangsseite des ersten ausgenommenen Abschnitts (800x) des Werkzeugs (800) in Kontakt sind;
Glätten der ersten Seite (90a) und einer zweiten Seite (90b) des Metallbasismaterials (90) durch Absenken des ersten Durchschlags (810) entlang des ersten ausgenommenen Abschnitts (800x), während der erste Durchschlag (810) in den ersten ausgenommenen Abschnitt (800x) eingreift, um Druck auf das Metallbasismaterial (90) auszuüben;
Platzieren des Metallbasismaterials (90), das die geglättete erste Seite (90a) und die geglättete zweite Seite (90b) aufweist, in einem zweiten ausgenommenen Abschnitt (900x) eines Werkzeugs (900), wobei der zweite ausgenommene Abschnitt (900x) eine planare Kreisform aufweist, und Anordnen des scheibenförmigen zweiten Durchschlags (910) auf der ersten Seite (90a) des Metallbasismaterials (90), derart, dass in einer Draufsicht zwischen der Außenumfangsseite (90c) des Metallbasismaterials (90) und einer Innenumfangsseite des zweiten ausgenommenen Abschnitts (900x) ein ringförmiger Spalt (900s) gebildet ist;
Bilden eines Grundkörpers (11), dessen Breite größer ist als eine Breite des Metallbasismaterials (90) durch Absenken des zweiten Durchschlags (910) entlang des zweiten ausgenommenen Abschnitts (900x), während der zweite Durchschlag (910) in den zweiten ausgenommenen Abschnitt (900x) eingreift, um am Metallbasismaterial (90), dessen erste Seite (90a) und zweite Seite (90b) geglättet sind, eine Schmiedeverarbeitung vorzunehmen; und
Bilden eines Durchgangslochs (12), das den Grundkörper (11) in einer Dickenrichtung durchdringt, durch Durchschlagen des Grundkörpers (11).

2. Verfahren nach Anspruch 1, wobei das Glätten ferner Folgendes umfasst:
Ausüben eines Drucks von einer gleichen Seite wie die ersten Seite (90a) des Metallbasismaterials (90) auf das Metallbasismaterial (90) durch Absenken des ersten Durchschlags (810), während der erste Durchschlag (810) mit der ersten Seite (90a) des Metallbasismaterials (90) in Kontakt ist;
Umdrehen des Metallbasismaterials (90) und Platzieren des umgedrehten Metallbasismaterials (90) im ersten ausgenommenen Abschnitt (800x); und
Ausüben eines Drucks von einer gleichen Seite wie die zweiten Seite (90b) des Metallbasismaterials (90) auf das Metallbasismaterial (90) durch Absenken des ersten Durchschlags (810), während der erste Durchschlag (810) mit der zweiten Seite (90b) des Metallbasismaterials (90) in Kontakt ist.

3. Verfahren nach Anspruch 1 oder 2, wobei beim Bilden des Grundkörpers (11), an einer Grenze zwischen der ersten Seite (11a) und einer Außenumfangsseite (11c) des Grundkörpers (11) und an einer Grenze zwischen der zweiten Seite (11b) und der Außenumfangsseite (11c) des Grundkörpers (11) eine abgerundete Kante gebildet wird, und
das Verfahren umfasst nach dem Bilden des Grundkörpers (11) ferner das Reduzieren von mindestens einer der abgerundeten Kante, die an der Grenze zwischen der ersten Seite (11a) und der Außenumfangsseite (11c) des Grundkörpers (11) gebildet ist, und der abgerundeten Kante, die an der Grenze zwischen der zweiten Seite (11b) und der Außenumfangsseite (11c) des Grundkörpers (11) gebildet ist, durch Ausüben eines Drucks auf den Grundkörper (11).

4. Verfahren nach Anspruch 3, wobei das Reduzieren der abgerundeten Kante ferner Folgendes umfasst:
Ausüben eines Drucks von einer gleichen Seite wie die ersten Seite (11a) des Grundkörpers (11) auf den Grundkörper (11); und
anschließendes Ausüben eines Drucks von einer gleichen Seite wie die zweiten Seite (11b) des Grundkörpers (11) auf den Grundkörper (11).

5. Verfahren nach einem der Ansprüche 1 bis 4, wobei das Bilden des Durchgangslochs (12) ferner das Durchschlagen des Grundkörpers (11) von der ersten Seite (11a) zur zweiten Seite (11b) umfasst,
wobei das Durchschlagen des Grundkörpers (11) von der ersten Seite (11a) zur zweiten Seite (11b) auf einer Innenumfangsseite des ersten Lochabschnitts (121) in einer Scherfläche und auf einer Innenumfangsseite eines zweiten Lochabschnitts (122) in einer Bruchfläche resultiert, wobei der erste Lochabschnitt (121) auf einer Seite der ersten Seite (11a) des Grundkörpers (11) gebildet ist und einen vorbestimmten Innendurchmesser aufweist, und der zweite Lochabschnitt (122) einen Innendurchmesser aufweist, der vom ersten Lochabschnitt (121) weg zur zweiten Seite (11b) des Grundkörpers (11) hin allmählich zunimmt.

6. Verfahren nach Anspruch 5, wobei die Innenumfangsseite (121a) des ersten Lochabschnitts (121) glatter ist als die Außenumfangsseite (11c) des Grundkörpers (11).

7. Verfahren nach einem der Ansprüche 1 bis 6, wobei das Bilden des Durchgangslochs (12) nach dem Anordnen des Durchschlags (920), der eine Form aufweist, bei der ein zylindrischer Abschnitt (921), ein abgeschnittener Kegelabschnitt (922) und ein umgekehrter abgeschnittener Kegelabschnitt (923) durchgehend gebildet sind, auf dem Grundkörper (11) ferner das Durchschlagen des Grundkörpers (11) in einer Weise, dass der umgekehrte abgeschnittene Kegelabschnitt (923) zuerst mit dem Grundkörper (11) in Kontakt kommt, umfasst.

## Revendications

1. Procédé de fabrication d'un œillet (1, 1A, 1B, 1C) comprenant les étapes suivantes :
former un matériau de base métallique (90) en coupant un matériau de fil métallique ;
placer le matériau de base métallique (90) dans une première partie évidée (800x) d'une matrice (800), la première partie évidée (800x) ayant une forme planaire circulaire et agencer un premier poinçon en forme de disque (810) sur une première face (90a) du matériau de base métallique (90), de sorte qu'une face circonférentielle externe du premier poinçon (810) et une face circonférentielle externe (90c) du matériau de base métallique (90) sont en contact avec la face circonférentielle interne de la première partie évidée (800x) de la matrice (800) ;
aplatir la première face (90a) et une seconde face (90b) du matériau de base métallique (90) en abaissant le premier poinçon (810) le long de la première partie évidée (800x) alors que le premier poinçon (810) se met en prise avec la première partie évidée (800x) afin d'appliquer une pression sur le matériau de base métallique (90) ;
placer le matériau de base métallique (90) ayant la première face aplatie (90a) et la seconde face aplatie (90b) dans une seconde partie évidée (900x) d'une matrice (900), la seconde partie évidée (900x) ayant une forme planaire circulaire, et agencer un second poinçon en forme de disque (910) sur la première face (90a) du matériau de base métallique (90), de sorte qu'un espace de forme annulaire (900s) sur une vue en plan est formé entre la face circonférentielle externe (90c) du matériau de base métallique (90) et une face circonférentielle interne de la seconde partie évidée (900x) ;
former un corps de base (11) dont la largeur est supérieure à une largeur du matériau de base métallique (90) en abaissant le second poinçon (910) le long de la seconde partie évidée (900x) alors que le second poinçon (910) se met en prise avec la seconde partie évidée (900x) afin d'appliquer un traitement de forge sur le matériau de base métallique (90) dont la première face (90a) et la seconde face (90b) sont aplaties ; et
former un trou débouchant (12) pénétrant à travers le corps de base (11) dans une direction d'épaisseur en poinçonnant à travers le corps de base (11).

2. Procédé selon la revendication 1, dans lequel l'aplatissement comprend en outre les étapes suivantes :
appliquer une pression sur le matériau de base métallique (90) à partir d'un même côté que la première face (90a) du matériau de base métallique (90) en abaissant le premier poinçon (810) alors que le premier poinçon (810) est en contact avec la première face (90a) du matériau de base métallique (90) ;
retourner le matériau de base métallique (90) et placer le matériau de base métallique (90) retourné dans la première partie évidée (800x) ; et
appliquer une pression sur le matériau de base métallique (90) à partir d'un même côté que la seconde face (90b) du matériau de base métallique (90) en abaissant le premier poinçon (810) alors que le premier poinçon (810) est en contact avec la seconde face (90b) du matériau de base métallique (90).

3. Procédé selon la revendication 1 ou 2, dans lequel lors du formage du corps de base (11), un bord arrondi est formé au niveau d'une limite entre la première face (11a) et une face circonférentielle externe (11c) du corps de base (11) et au niveau d'une limite entre la seconde face (11b) et la face circonférentielle externe (11c) du corps de base (11), et
le procédé comprend en outre, après le formage du corps de base (11), la réduction d'au moins l'un parmi le bord arrondi formé au niveau de la limite entre la première face (11a) et la face circonférentielle externe (11c) du corps de base (11) et le bord arrondi formé au niveau de la limite entre la seconde face (11b) et la face circonférentielle externe (11c) du corps de base (11) en appliquant une pression sur le corps de base (11) .

4. Procédé selon la revendication 3, dans lequel la réduction du bord arrondi comprend en outre les étapes suivantes :
appliquer une pression sur le corps de base (11) à partir d'un même côté que la première face (11a) du corps de base (11) ; et
appliquer, ensuite, une pression sur le corps de base à partir d'un même côté que la seconde face (11b) du corps de base (11).

5. Procédé selon l'une quelconque des revendications 1 à 4, dans lequel le formage du trou débouchant (12) comprend en outre le poinçonnage du corps de base (11) de la première face (11a) à la seconde face (11b) ,
dans lequel le poinçonnage du corps de base (11) de la première face (11a) à la seconde face (11b) se traduit par une surface de cisaillement sur une face circonférentielle interne d'une première partie de trou (121) et une surface de fracture sur une face circonférentielle interne d'une seconde partie de trou (122), la première partie de trou (121) étant formée au niveau d'un côté de la première face (11a) du corps de base (11) et ayant un diamètre interne prédéterminé, et la seconde partie de trou (122) ayant un diamètre interne augmentant progressivement à l'opposé de la première partie de trou (121) vers la seconde face (11b) du corps de base (11).

6. Procédé selon la revendication 5, dans lequel la face circonférentielle interne (121a) de la première partie de trou (121) est plus lisse que la face circonférentielle externe (11c) du corps de base (11).

7. Procédé selon l'une quelconque des revendications 1 à 6, dans lequel le formage du trou débouchant (12) comprend en outre le poinçonnage du corps de base (11) après avoir agencé un poinçon (920) qui a une forme dans laquelle une partie cylindrique (921), une partie tronconique (922) et une partie tronconique inversée (923) sont formées de manière continue, sur le corps de base (11) de sorte que la partie tronconique inversée (923) vient en contact en premier avec le corps de base (11).
